# EUROPEAN PATENT SPECIFICATION

(11) **EP 2 492 369 B1**
(45) Date of publication and mention of the grant of the patent: **15.08.2018**
(21) Application number: 10824643.0
(22) Date of filing: 18.10.2010
(51) Int. Cl.: C23C 16/44, C23C 16/54

(54) **CVD FILM FORMING DEVICE**
VORRICHTUNG ZUR FORMUNG EINES FILMS DURCH CHEMISCHE DAMPFABLAGERUNG
DISPOSITIF DE FORMATION DE FILM PAR CVD

(30) Priority: 22.10.2009 JP 2009243215
(43) Date of publication of application: 29.08.2012
(73) Proprietor: Kabushiki Kaisha Kobe Seiko Sho, Chuo-ku Kobe-shi Hyogo 651-8585 (JP)
(72) Inventor: SEGAWA, Toshiki, Takasago-shi Hyogo 676-8670 (JP); OKIMOTO, Tadao, Takasago-shi Hyogo 676-8670 (JP); TAMAGAKI, Hiroshi, Takasago-shi Hyogo 676-8670 (JP)
(74) Representative: TBK
(86) International application number: PCT/JP2010/006157
(87) International publication number: WO 2011/048790

(56) References cited:
- JP-A- 9 111 458
- JP-A- 2008 024 990
- JP-A- 2008 115 412
- JP-A- 2008 169 434
- US-A- 4 723 507

## Description

### TECHNICAL FIELD

The present invention relates to a CVD apparatus for performing deposition processing on a plastic film or sheet by plasma CVD.

### BACKGROUND ART

Conventionally, there is a CVD apparatus configured so that a pair of roller electrodes is opposed to each other, and deposition processing is performed by plasma CVD on a strip substrate such as a film or sheet which is transferred while being rolled on these roller electrodes (refer to Fig. 1 of Patent Literature 1). Each of the above-mentioned roller electrodes has a roller and a magnetron magnet provided inside the roller, and forms magnetron discharge plasma on the roller by applying a voltage to the roller. In this state, a precursor source gas such as HMDSO is supplied to between these roller electrodes and plasma-decomposed, whereby a coating composed of SiOxCy or the like is formed on the base film.

In this CVD apparatus, the source gas is introduced to a position above the pair of roller electrodes, and discharged through a discharge port below the roller electrodes. The source gas thus flows in a vertical direction. This CVD apparatus further includes free rollers (driven rollers) arranged above and outside the pair of roller electrodes. The base film is rolled, from the outside and underside of the roller electrodes, on one roller electrode at a winding angle of about 180°, further on both the free rollers, and then on the other roller electrode at a winding angle of about 180°. Thus, the base film travels on the upper side of a position to which the source gas is supplied so as not to disturb the flow of the source gas. According to such a film traveling path, even if a part of a film adhered to the roller electrode or a peripheral member thereof is peeled off, the probability that a broken piece thereof falls onto the base film can be reduced to prevent damages on the base film due to entangling of the peeled film or the like.

On the other hand, for improving productivity, a CVD apparatus in which two pairs of roller electrodes are vertically arranged is also proposed (refer to Fig. 3 of Non-patent Literature 1). In this CVD apparatus, deposition processing is performed on the four roller electrodes by supplying an AC power to the upper pair of roller electrodes and the lower pair of roller electrodes from one power source, whereby the productivity of a film or the like to be subjected to the deposition processing is improved.

In conventional CVD apparatuses as described above, increase in deposition rate (improvement in productivity) and multilayer formation are highly demanded.

To respond to such a demand, in the CVD apparatus of Patent Literature 1, it can be thought to increase the deposition rate by increasing the power to be supplied as well as the feed of the precursor source gas. In this case, however, since the heat input to the base film increases according to the increase in deposition rate, the input power must be limited to avoid film damages thereby. Although it is also possible to cool the film by cooling the roller electrodes with water, the cooling capability is naturally limited. Therefore, in a CVD apparatus provided with a pair of electrode rollers as in Patent Literature 1, it is difficult to remarkably increase the deposition rate.

With respect to the multilayer formation, even in the CVD apparatus of Patent Literature 1 provided with only a pair of roller electrodes, a multilayer film can be formed by performing deposition processing on the same base film by a plurality of passes in varied deposition conditions while reciprocally transferring the base film. However, it is not necessarily efficient to perform a plurality of paths of deposition processing while reciprocally transferring the base film in this way.

On the other hand, in the CVD apparatus of Non-patent Literature 1 in which the productivity is improved by performing the power feeding to two pairs of vertically arranged roller electrodes entirely from one power source, it can be thought to increase the deposition rate, as an extension of this idea, by adding a power source and further increasing the number of roller electrode pairs. It can be also thought to form a multilayer film by one-pass processing by performing coating processing on the same base film while varying the coating condition for each roller electrode pair.

However, in the CVD apparatus of Non-patent Literature 1 in which the roller electrodes are vertically arranged, a film deposited on and peeled from the roller electrodes on the upper side or the like can fall onto the base film on the lower roller electrode pair and be entangled to the base film, causing a defect such as film defect or film impression. Moreover, the weight per unit area tends to increase due to the vertical arrangement of the plurality of pairs of roller electrodes, and the installation site is limited in terms of load resistance.

Namely, in the CVD apparatus of Patent Literature 1, it is difficult to remarkably improve the deposition rate or to efficiently form a multilayer film by one pass. On the other hand, the CVD apparatus of Non-patent Literature 1 can involve entangling of a peeled film or the like although it is advantageous from the viewpoint of improvement in deposition rate and efficient multilayer formation.

### CITATION LIST

### PATENT LITERATURE

PATENT LITERATURE 1: Japanese Patent No. 4268195

### NON-PATENT LITERATURE

NON-PATENT LITERATURE: Hiroshi TAMAGAKI, Tadao OKIMOTO, "Roller-to-roller Plasma CVD Device", Convertech, Editorial Department of Converting Technical Institute, September 15, 2006, JP2008024990 A discloses a plasma assisted CVD apparatus with coating stations which each comprise a pair of opposed deposition rollers.

### SUMMARY OF INVENTION

In view of the above-mentioned problems, the present invention has been achieved and has an object to provide a CVD apparatus, capable of improving productivity without a risk such as damage by entangling of a peeled film.

To attain this object, a CVD apparatus according to the present invention as set forth in claim 1 for forming a coating on a surface of a sheet-like substrate by plasma CVD includes: a plurality of deposition chamber units each including deposition rollers and a deposition unit chamber for housing the deposition rollers, the deposition chamber units being arranged so that each deposition roller is aligned in a specific horizontal direction; and a connection chamber unit which is interposed between mutually adjacent deposition chamber units of the deposition chamber units to mutually connect the adjacent deposition chamber units, in which the connection chamber unit includes a connection unit chamber which connects the adjacent deposition chamber units to each other by being connected to each deposition unit chamber of the adjacent deposition chamber units, and the deposition rollers of each deposition chamber unit are arranged so that the substrate is transferred while being rolled on the respective deposition rollers, and are configured so that plasma for decomposing a source gas is formed, upon receiving application of a voltage, in the vicinity of the deposition rollers to perform deposition processing on the substrate on the deposition rollers.

In this device, since a plurality of deposition chamber units are arranged so that the deposition rollers are aligned in a horizontal direction, deposition processing can be performed on the substrate in the plurality of deposition chamber units while transferring the substrate, while a film deposited on and peeled from the deposition rollers or the like can be prevented from falling onto the substrate.

### BRIEF DESCRIPTION OF DRAWINGS

[Fig. 1] Fig. 1 is a front view of a CVD apparatus according to the present invention.
[Fig. 2]: Fig. 2 is an enlarged view showing a deposition chamber unit and a connection chamber unit in the CVD apparatus.
[Fig. 3]: Fig. 3 is a front view showing a modified example of the CVD apparatus.

### DESCRIPTION OF EMBODIMENTS

An embodiment of the present invention will be described based on the drawings.

In the drawings, the same reference signs are assigned to the same components having the same name and function.

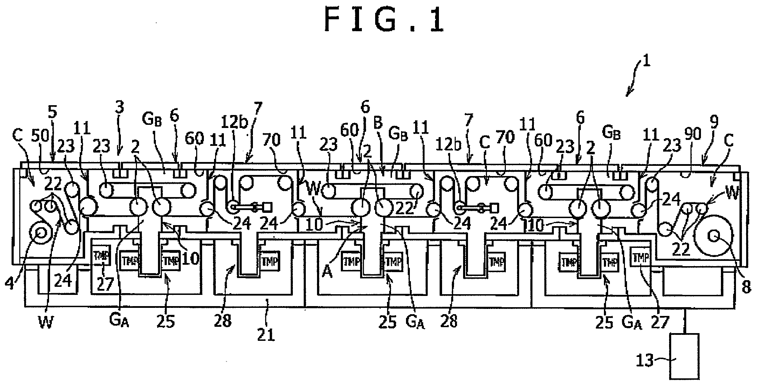

Fig. 1 shows an overall configuration of a CVD apparatus 1 according to the present invention.

The CVD apparatus 1 of the present invention is provided with a plurality of deposition rollers 2 aligned in a horizontal direction, and a vacuum chamber 3 for housing the plurality of deposition rollers 2, and is configured to perform deposition processing by plasma CVD to a substrate W on the deposition rollers 2 by applying an AC voltage or a pulse-like voltage with polarity reversion to the deposition rollers 2 while transferring the substrate W in a state where the substrate W is rolled on the deposition rollers 2, and plasma-decomposing a source gas supplied to the vicinity of the deposition rollers 2.

This CVD apparatus 1 includes: a delivery chamber unit 5 including a feed roller 4 from which a substrate W is unwound; a takeup chamber unit 9 including a takeup roller 8 on which the substrate W is wound up; three deposition chamber units 6 each including a pair of deposition rollers 2, 2 (corresponding to opposed rollers of the present invention); two connection chamber units 7 interposed respectively between adjacent deposition chamber units 6 to mutually connect the adjacent deposition chamber units 6; and a frame 21 on which these units 5 to 9 axe supported and fixed. The delivery chamber unit 5 is arranged at a position on the most upstream side, and the takeup chamber unit 9 is arranged at a position on the most downstream side. Between the delivery chamber unit 5 and the takeup chamber unit 9, the three deposition chamber units 6 and the two connection chamber units 7 are alternately arranged in row in a horizontal direction, so that the substrate W is taken up by the takeup chamber unit 9 via the film chamber units 6 and the connection chamber units 7 while being unwound from the delivery chamber unit 5.

Namely, this CVD apparatus 1 is constituted by a combination of a plurality of standardized units 5 to 9, and the vacuum chamber 3 is constituted by unit chambers 50 to 90 to be described of these units 5 to 9. Therefore, this CVD apparatus 1 can be manufactured at low cost, compared with a case in which the whole body is integrally constituted, and the CVD apparatus 1 further can be easily produced in an optional size by changing the number of the deposition chamber units 6.

As the substrate W on which a coating is formed, an insulating material which can be taken up in roll, such as a plastic film or sheet or paper, can be considered. As the plastic film or sheet, PET, PEN, PES, polycarbonate, polyolefin, polyimide and the like are appropriate, and the thickness of the substrate W is preferably 25 µm to 0.5 mm which allows the transfer in vacuum.

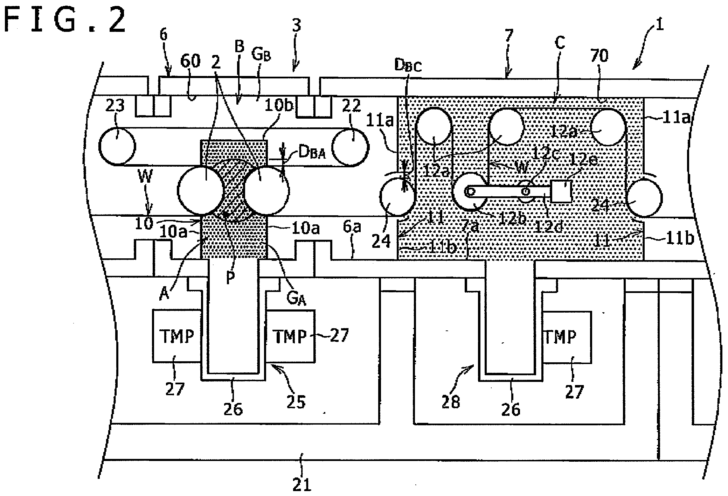

The CVD apparatus 1 will be then described in detail based on Figs. 1 and 2.

The delivery chamber unit 5 includes: a feed roller 4, a plurality of near rollers 22, a tension detection roller 23, and a delivery unit chamber 50 for housing these rollers 4, 22, 23. The feed roller 4 is a bobbin having a plastic core (roller core), and the substrate W is transferred toward the deposition chamber units 6 through the near rollers 22, the tension detection roller 23 and a pressure barrier roller 24 to be described while being unwound from the feed roller 4.

Each of the near rollers 22 is a rotatable free roller. These near rollers 22 are rotatably supported by a movable member not shown, and this movable member is position-controlled so that the near rollers 22 are regularly located in the vicinity of the outer periphery of the substrate W wound around the feed roller 4. According to this, the substrate W unwound from the feed roller 4 is prevented from being vertically wrinkled.

The tension detection roller 23 for detecting a tension applied to the substrate W is configured to measure a force acting on a roller support portion by use of a load cell or the like. In this delivery chamber unit 5, the rotating speed of the feed roller 4 or the like is feedback-controlled so that the measured value is constant.

The delivery chamber unit 5 is provided with a differential pressure interruption means for partitioning the inside thereof (the inside of the delivery unit chamber 50: a decompressed area C to be described) from the inside of the deposition chamber unit 6 adjacent to the delivery chamber unit 5 (the inside of a deposition unit chamber 60 to be described: a pressurized area B to be described). The connection chamber unit 7 to be described is also provided with such a differential pressure interruption means, and this differential pressure interruption means will be described in detail in relation to the description of the connection chamber unit 7.

The deposition chamber unit 6 includes, as shown in Figs. 1 and 2, a pair of deposition rollers 2, 2, a free roller 22, a tension detection roller 23, and a deposition unit chamber 60 for housing these rollers 2, 22, 23. The pair of deposition rollers 2, 2, which are cylinders formed of a stainless material or the like and having the same diameter and the same length, are arranged so that the respective rotation centers are located substantially at the same height from a bottom wall (floor surface) 6a within each deposition chamber unit 6 with the respective shaft centers being parallel to each other and horizontal. The tension detection roller 23 and the free roller 22 are installed, above the deposition rollers 2, 2, at outside positions in the arrangement direction of the deposition rollers 2, 2. The substrate W is rolled on the deposition roller 2 on the upstream side, further on the tension detection roller 23 and the free roller 22, and then on the deposition roller 2 on the downstream side. Specifically, the substrate W is rolled on one deposition roller 2 from the outside and lower side of the deposition rollers 2, 2 at a winding angle of about 180°, further rolled on the tension detection roller 23 and the free roller 22, and then rolled on the other deposition roller 2 from the upper side at a winding angle of about 180°.

Each of the deposition chamber units 6 is arranged so that the respective pair of deposition rollers 2, 2 is aligned at substantially the same height position in the horizontal direction.

The pair of deposition rollers 2, 2 of the deposition chamber unit 6 is electrically insulated from each other in addition to from the deposition unit chamber 60 (vacuum chamber 3), and connected to both poles of one plasma power source (not shown) respectively. This plasma power source generates a middle/high frequency AC voltage or a pulse-like voltage with the polarities of both poles being reversible.

Each of the deposition rollers 2, 2 includes a vacuum seal portion, a power feeding portion, a cooling water inlet portion which are not shown, and a magnetic field generating member to be described is disposed inside thereof. These deposition rollers 2, 2 are independently drive-controlled by a roller control means 13 to be described.

The deposition chamber unit 6 is further provided with a deposition area partition member 10 inside thereof (within the deposition unit chamber 60). The deposition area partition member 10 encloses an area on the side where the deposition rollers 2, 2 are mutually opposed to thereby isolate this area from the outside area. The deposition area partition member 10 is a partition wall formed of a stainless material. This deposition area partition member 10 includes side walls 10a each perpendicularly extending upward from the bottom wall 6a at the positions of rotation center of the respective deposition rollers 2, 2, and an upper wall 10b connecting the upper ends of the side walls 10a to each other to close the space above the deposition rollers 2, 2, whereby the inside of the deposition chamber unit 6 is partitioned into an inside deposition area A enclosed by the deposition area partition member 10 and a pressurized area B outside thereof.

The deposition area A is filled with a source gas GA, while the pressurized area B is filled with a pressurized discharge gas G_{B} higher in pressure than the source gas G_{A}.

The deposition area A is equipped with a source gas supply means (not shown) for supplying the source gas GA and a source gas discharge means 25 for discharging the source gas G_{A} from the deposition area A. On the other hand, the magnetic field generating member (not shown) for forming a predetermined magnetic field in the space between the deposition rollers 2, 2 is provided inside each of the deposition rollers 2, 2 so as to form plasma on the mutually opposed surfaces of the deposition rollers 2, 2. The substrate W is rolled on the deposition rollers 2, 2 so as to pass through a plasma area P in which the plasma is formed. Namely, the source gas G_{A} is supplied to between the deposition rollers 2, 2 with the middle/high-frequency AC or pulse voltage being applied to the deposition roller 2, 2 from the plasma power source, whereby plasma is generated by glow discharge in the opposed space of the deposition rollers 2, 2, and this plasma is collected to the vicinity of the surfaces of the deposition rollers 2, 2 by the magnetic field generation means to form the above-mentioned plasma area P that is a deposition area between the deposition rollers 2, 2. Therefore, the source gas supply means is arranged so as to inject the source gas G_{A} toward this plasma area P. The source gas supply means is preferably located above the source gas discharge means 25. In addition to the source gas, a reaction gas or an auxiliary gas is also appropriately supplied to the deposition area A.

The pressurized area B is equipped with a pressurized discharge gas supply means (not shown) for supplying the source gas G_{A}, and is filled with the pressurized discharge gas G_{B} so as to be higher in pressure than the inside of the deposition area A. As the pressurized discharge gas G_{B}, a gas such as oxygen, nitrogen or Ar is preferred.

As shown in Fig. 2, a gap D_{BA} is provided between the deposition rollers 2, 2, and the deposition area partition member 10. Specifically, the side wall 10a is in no contact with the surface of the deposition rollers 2, 2, and the gap D_{BA} is formed between the side wall 10a and the surface of the deposition rollers 2, 2.

The above-mentioned gap D_{BA} between the deposition roller 2, 2 and the deposition area partition member 10 has a clearance such that the circulation of gas from the deposition area A to the pressurized area B can be suppressed while allowing the passage of the substrate W rolled on the deposition rollers 2, 2. For example, a shorter gap length of the gap D_{BA} is more preferred, and the gap length is preferably set to about 2 to 3 mm.

The source gas discharge means 25 is arranged below each deposition roller 2. In detail, the source gas discharge means 25 includes an auxiliary chamber unit 26 communicating with the inside of the deposition area A through an opening formed in the bottom wall 6a of the deposition unit chamber 60 of the deposition chamber unit 6, and a turbo molecular pump 27 mounted on this auxiliary chamber unit 26.

The source gas discharge means 25 has a function to decompress the deposition area A prior to coating operation or to discharge the source gas G_{A} supplied from the source gas supply means which has contributed to deposition to the outside of the deposition unit chamber 60.

The turbo molecular pump 27 is composed of a mechanical vacuum pump having turbine blades, and is attached horizontally to a side surface of the auxiliary chamber unit 26. According to this, a trouble such that a peeled film which is peeled from the substrate W during deposition directly falls onto the turbo molecular pump 27 to damage the turbine blades can be prevented while allowing the communication of the deposition area A with the auxiliary chamber unit 26 just below the plasma area P.

The connection chamber unit 7 is arranged each between the deposition chamber units 6. The connection chamber unit 7 is interposed between the adjacent deposition chamber units 6 to mutually connect the adjacent deposition chamber units 6, and is configured to transfer the substrate W while keeping the tension of the substrate W constant between these deposition chamber units 6.

The connection chamber unit 7 includes, as shown in Fig. 2, three free rollers 12a aligned in a horizontal direction, a dancer roller 12b arranged between two free rollers 12a on the upstream side of these free rollers 12a, and a connection unit chamber 70 for housing these rollers 12a, 12b. The free rollers 12a are rotatably supported by the connection unit chamber 70, and the dancer roller 12b is rotatably supported at one end of a dancer arm 12d which is swingably supported by the connection unit chamber 70 through a pivotal shaft 12c. Denoted by 12d is a counter weight 12e provided at the other end of the dancer arm 12d. Namely, when the length of the substrate W between the deposition rollers 2 on both sides (upstream and downstream sides) of the connection chamber unit 7 is changed due to differed rotating speeds of both the rollers, the dancer roller 12b is oscillated at a torque corresponding to a predetermined tension around the pivotal shaft 12c to change the traveling distance of the substrate W between the free rollers 12a, whereby the difference in rotating speed between the deposition rollers 2, 2 is absorbed, and the tension of the substrate W is maintained at a fixed level.

The CVD apparatus 1 includes an encoder (corresponding to the position detection means of the present invention) provided on the pivotal shaft 12c to detect a position of the dancer roller 12b, and a roller control means 13 which controls the rotating speed of each deposition roller 2. For example, when the encoder detects that the dancer roller 12b is displaced downward to extend the traveling distance of the substrate W, the roller control means 13 controls the rotating speed of the deposition roller 2 on the upstream side of the connection chamber unit 7 so as to become lower than the rotating speed of the deposition roller 2 on the downstream side, and when the dancer roller 12b is conversely displaced upward to reduce the traveling distance of the substrate W, the roller control means 13 controls the rotating speed of the deposition roller 2 on the downstream side so as to become lower than the rotating speed of the deposition roller 2 on the upstream side. In this way, the rotating speeds of the deposition rollers 2 located at both ends of the connection chamber unit 7 are controlled based on the position of the dancer roller 12b, whereby the displacement margin of the dancer roller 12b is appropriately secured while maintaining the tension of the substrate W.

The connection chamber unit 7 includes differential pressure interruption means provided respectively at upstream and downstream end portions thereof. Each of the differential pressure interruption means partitions the inside of the connection unit chamber 70 of the connection chamber unit 7 from the inside of the deposition unit chamber 60 of the deposition chamber unit 60 while allowing the passage of the substrate W to form a decompressed area C isolated from the pressurized area B inside the connection chamber unit 7. The differential pressure interruption means includes, as shown in Fig. 2, a pressure barrier roller 24 composed of a free roller rotatably supported by the connection unit chamber 70, and a partition member 11 fixed to the connection unit chamber 70. The partition member 11 has an upper wall portion 11a located above the pressure barrier roller 24 and a lower wall portion 11b located below it. The pressure barrier roller 24 is in no contact with each wall portion 11a, 11b, whereby a gap D_{BC} is formed between the surface of the pressure barrier roller 24 and each wall portion 11a, 11b as shown in the same figure. This gap D_{BC} also has a clearance such that the circulation of gas from the pressurized area B to the decompressed area C can be suppressed while allowing the passage of the substrate W similarly to the above-mentioned gap D_{BA}.

In addition to the connection chamber unit 7, the decompressed area C is also formed inside the delivery chamber unit 5 and the takeup chamber unit 9 to be described, and these decompressed areas C are partitioned from the pressurized areas B of the deposition chamber units 6 adjacent thereto by the differential pressure interruption means provided respectively in the delivery chamber unit 5 and the takeup chamber unit 9. Namely, the decompressed areas C are located on the upstream side and downstream side of each pressurized area B.

A pressurized discharge gas discharge means 28 is provided in the decompressed area C, and the pressure inside the decompressed area C is decompressed to a pressure lower than in the pressurized area B by the pressurized discharge gas discharge means 28. In detail, the pressurized discharge gas discharge means 28 includes an auxiliary chamber unit 26 which communicates with the inside of the deposition area C through an opening formed in a bottom wall 7a of the connection unit chamber 70 of the connection chamber unit 7, and a turbo molecular pump 27 which is mounted on the auxiliary chamber unit 26. In the delivery chamber unit 5 and the takeup chamber unit 9, turbo molecular pumps 27 are directly mounted on side walls thereof respectively. Thus, the pressure inside the decompressed area C is decompressed.

Three free rollers 12a are provided in the connection chamber unit 7 in order to change the transferring direction of the substrate W while maintaining a certain level of winding angle to obtain a grip force with the substrate W. The number of the free rollers 12a is not limited to three.

The takeup chamber unit 9 includes a takeup roller 8, a plurality of near rollers 22, a tension detection roller 23, a takeup unit chamber 90 for housing these rollers 8, 22, 23, and further the above-mentioned differential pressure interruption means for partitioning the inside of the takeup chamber unit 9 from the inside of the deposition chamber unit 6 adjacent to the takeup chamber unit 9, in which the substrate W which has been subjected to deposition is taken up on the takeup roller 8 through a pressure barrier roller 24, the tension detection roller 23 and the near rollers 22. The inside of the takeup chamber unit 9 is the decompressed area C as described above.

This CVD apparatus 1 can operate each deposition chamber unit 6 in different deposition conditions, and thus can perform multilayer formation by one pass by taking up the substrate W by the takeup chamber unit 9 while delivering it from the delivery chamber unit 5. When deposition processing is performed on the substrate W under different deposition conditions for each of the deposition chamber units 6 in this way, circulation of the source gas or the like between the adjacent deposition chamber units 6 affects the deposition quality. Therefore, in this CVD apparatus 1, the gas supply by the source gas supply means or the pressurized discharge gas supply means or the like is controlled by the control means (not shown), thereby the pressures in the deposition area A, the pressurized area B and the decompressed area C are adjusted as described below.

With respect to the deposition chamber unit 6, the pressure is adjusted to "Pressure P_{A} of deposition area A (source gas G_{A}) ≤Pressure P_{B} of pressurized area B (pressurized discharge gas G_{B})" by controlling the pressurized discharge gas supply means provided on the pressurized area B side while appropriately controlling the source gas supply means and the source gas discharge means 25, whereby the source gas G_{A} is prevented from flowing from the deposition area A to the pressurized area B through the gap D_{BA} between the deposition rollers 2, 2 and the deposition area partition member 10. The pressure P_{A} of the deposition area A is, for example, 1 to several Pa, and the pressure P_{B} of the pressurized area B is slightly higher than the pressure P_{A} of the deposition area A.

With respect to each connection chamber unit 7, the delivery chamber unit 5 and the takeup chamber unit 9, the pressure Pc of the decompressed area C and the pressure P_{B} of the pressurized area B are adjusted to "Pressure P_{C} in decompressed area C ≤Pressure P_{B} of pressurized area B (pressurized discharge gas G_{B})" by appropriately controlling the pressurized discharge gas discharge means 28 and pressurized discharge gas supply means of the deposition chamber unit 6 adjacent thereto. Accordingly, the inflow of gas from the decompressed area C to the pressurized are B through the gap D_{BC} of the partition member 11 is prevented. The pressure Pc of the decompressed area C is, for example, 1 Pa or less.

Namely, in each deposition chamber unit 6, since the pressure P_{A} of the deposition area A is lower than the pressure P_{B} of the peripheral pressurized area B, the source gas G_{A} never flows to the pressurized area B. Since the pressurized areas B of the adjacent deposition chamber units 6 are pressure-separated from each other by the pressurized area C of the connection chamber unit 7 interposed between the both, the source gas G_{A} used in one deposition chamber unit 6 of the adjacent deposition chamber units 6 never flows to the deposition area A of the other deposition chamber unit 6. Therefore, the deposition is performed in an independent gas atmospheric condition in the deposition area A of each deposition chamber unit 6, and the CVD apparatus 1 can thus appropriately perform multilayer formation on the substrate W by one pass.

In general, a pressure setting such as "Pressure P_{C} of decompressed area C≤Pressure P_{A} of deposition area A≤Pressure P_{B} of pressurized area B" is adopted.

The procedure for performing deposition on the substrate W by the above-mentioned CVD apparatus 1 will be then described.

Firstly, prior to coating operation, each of the discharge means 25, 28 is operated to decompress each of the areas A to C. Thereafter, the source gas G_{A} and the pressurized discharge gas G_{B} are supplied respectively into the deposition area A and the pressurized area B of each deposition chamber unit 6 by controlling each supply means. The pressure within each of the areas A to C is adjusted and maintained so as to attain "Pressure P of deposition area A≤Pressure P of pressurized area B" and "Pressure P of decompressed area C≤Pressure P of pressurized area B" by controlling each discharge means 25, 28.

Thereafter, in each deposition chamber unit 6, a middle/high-frequency AC or pulse-like voltage is applied to the pair of deposition rollers 2, 2 from the plasma power source. When the voltage is applied to the deposition rollers 2, 2 in this way, glow discharge occurs in the opposed space of the deposition rollers 2, 2 to generate plasma. This plasma is collected onto the surfaces of the deposition rollers 2, 2 by the magnetic field generation means to form a plasma area P. The source gas GA supplied from the source gas supply means arrives at the plasma area P, and is plasma-decomposed therein, whereby a coating is formed on the substrate W by the plasma CVD process.

In such a situation, the substrate W unwound from the feed roller 4 is continuously transferred over a plurality of deposition chamber units 6, and passed through each plasma area P while being rolled on the deposition rollers 2, 2 aligned in the horizontal direction of each deposition chamber unit 6, whereby the substrate W is taken up on the takeup roller 8 while being subjected to deposition processing a plurality of times.

As described above, in the CVD apparatus 1 of the present invention, since the plurality of deposition chamber units 6 are arranged so that the deposition rollers 2 are aligned in the horizontal direction, a film deposited on and peeled from the deposition roller 2 or the like can be effectively prevented from falling onto the substrate 2 while transferring and subjecting the substrate W to deposition processing in the plurality of deposition chamber units 6. Therefore, according to this CVD apparatus 1, the productivity of a film or the like can be improved without a risk such as damage by entangling of a peeled film or the like.

According to this CVD apparatus 1, also, when a different deposition condition is set for each deposition chamber unit 6, multilayer formation can be performed on the substrate W by one pass by taking up the substrate W by the takeup chamber unit 9 while delivering the substrate W from the delivery chamber unit 5. Therefore, the productivity of a film or the like subjected to multilayer forming processing can be improved without a risk such as damage by entangling of a peeled film or the like. Furthermore, according to the CVD apparatus 1, since inflow of the source gas G_{A} to the respective deposition areas A in the mutually adjacent deposition chamber units 6 can be prevented as described above, high-quality multilayer forming processing can be performed on the substrate W.

Further, since the CVD apparatus 1 is configured so that a plurality of chamber units 5 to 9 are aligned in the horizontal direction, the height of the CVD apparatus 1 can be kept low. Therefore, with respect to the installation site of the CVD apparatus 1, the conditions for load resistance can be advantageously relaxed.

The embodiment disclosed herein is illustrative and not restrictive in every aspect. The scope of the present invention is defined by the appended claims, and equivalence of the claims and all changes that fall within the claims are intended to be embraced by the claims.

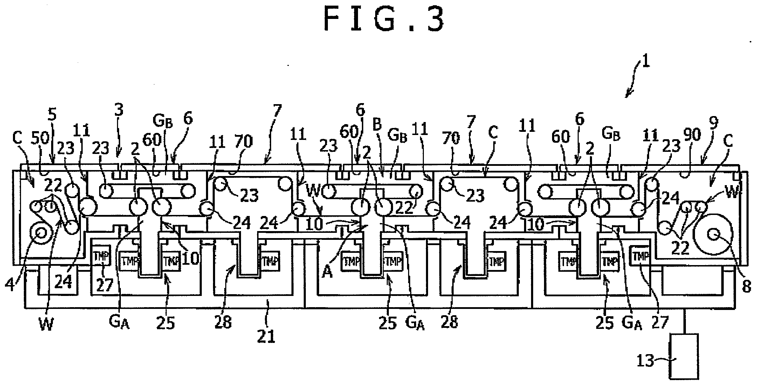

As shown in Fig. 3, in the connection chamber unit 7, a tension detection roller 23 may be provided instead of the dancer roller 12b or the like. Namely, based on a tension detected by the tension detection roller 23, the roller control means 13 may control the rotating speed of the deposition rollers 2 located at both sides of the connection chamber unit 7 so that the detected tension is constant. According to such a configuration, also, the substrate W can be stably transferred while keeping the tension applied to the substrate W constant.

The number of the free rollers in the connection chamber unit 7 can be properly changed.

As the deposition rollers 2 of each deposition chamber unit 6, one roller may be arranged in each deposition chamber 6 without being limited to a configuration in which two rollers are paired as opposed rollers. However such an arrangement is not in accordance with the claimed invention.

Although each deposition roller 2 is aligned in the horizontal direction in the above description, the line mutually connecting the rotation centers of the respective deposition rollers 2 does not have to be perfectly horizontal.

Further, optional sets of the deposition chamber unit 6 and the connection chamber unit 7 other than three sets may be connected between the delivery chamber unit 5 and the takeup chamber unit 9. For example, the CVD apparatus 1 can be configured to have one or two, or four or more deposition chamber units 6 and connection chamber units 7.

The present invention illustrated above can be summarized as follows.

Namely, the CVD apparatus of the present invention for forming a coating on a surface of a sheet-like substrate by plasma CVD includes: a plurality of deposition chamber units each including deposition rollers and a deposition unit chamber for housing the deposition rollers, the deposition chamber units being arranged so that each deposition roller is aligned in a specific horizontal direction; and a connection chamber unit which is interposed between mutually adjacent deposition chamber units of the deposition chamber units to mutually connect the adjacent deposition chamber units, in which the connection chamber unit includes a connection unit chamber which connects the adjacent deposition chamber units to each other by being connected to each deposition unit chamber of the adjacent deposition chamber units, and the deposition rollers of each deposition chamber unit are arranged so that the substrate is transferred while being rolled on the respective deposition rollers, and are configured so that plasma for decomposing a source gas is formed, upon receiving application of a voltage, in the vicinity of the deposition rollers to perform deposition processing on the substrate on the deposition rollers.

According to such a CVD apparatus, since a plurality of deposition chamber units are arranged so that the deposition rollers are aligned in the horizontal direction, deposition processing can be performed on the substrate in the plurality of deposition chamber units while transferring the substrate, while a film deposited on and peeled from the deposition roller or the like can be prevented from falling onto the substrate.

This CVD apparatus further includes: a delivery chamber unit including a feed roller from which the substrate is unwound and a delivery unit chamber for housing the feed roller; and a takeup chamber unit including a takeup roller on which the substrate is wound up and a takeup unit chamber for housing the takeup roller, in which the deposition chamber units and the connection chamber unit are disposed between the delivery chamber unit and the takeup chamber unit.

According to this configuration, the substrate is delivered from the delivery chamber unit, subjected to deposition via the plurality of deposition chamber units, and finally wound up by the takeup chamber unit. Therefore, the deposition processing can be efficiently performed on the substrate while transferring the substrate in a specific direction.

In the above-mentioned CVD apparatus, each deposition chamber unit includes, as the deposition rollers, a pair of opposed rollers which are opposed with a space therebetween for forming the plasma so that the shaft centers thereof are parallel to each other.

According to this configuration, the substrate can be subjected to deposition processing on each opposed roller while forming the plasma between the opposed rollers in a state where the substrate is rolled on each opposed roller. Therefore, the deposition processing can be efficiently performed on the substrate by a rational configuration.

In the above-mentioned CVD apparatus, the deposition chamber unit includes a deposition area partition member which partitions the inside of the deposition unit chamber into a deposition area that is a part or all of the area on the side where the pair of opposed rollers are opposed to each other and a pressurized area that is the peripheral area of the deposition area while allowing the passage of the substrate, the deposition area is filled with the source gas, and the pressurized area is filled with a pressurized discharge gas higher in pressure than the source gas.

According to this configuration, the source gas can be concentrated to the vicinity of the deposition rollers while preventing the diffusion thereof to appropriately perform deposition treatment on the substrate.

The above-mentioned CVD apparatus also includes a differential pressure interruption means which partitions the inside of the deposition unit chamber of the deposition chamber unit from the inside of the connection unit chamber of the connection chamber unit while allowing the passage of the substrate, and the inside of the connection unit chamber of the connection chamber unit is kept at a pressure lower than in the inside of the deposition unit chamber of the deposition chamber unit.

According to this configuration, the inflow of outside air to the deposition chamber unit can be prevented. Therefore, the effect of the inflow of outside air on the deposition processing can be eliminated, and the deposition processing on the substrate in each deposition chamber unit can be appropriately performed.

In the above-mentioned CVD apparatus, the connection chamber unit includes a dancer roller for keeping the tension of the substrate constant by displacing according to a change in length of the substrate between the deposition rollers located at both sides of the connection chamber unit.

According to this configuration, the tension of the substrate can be kept substantially constant by displacing the dancer roller according to the change of the substrate length. Therefore, the substrate can be smoothly transferred between the adjacent deposition chamber units while maintaining the tension thereof in a proper range.

This CVD apparatus preferably includes a position detection means for detecting a position of the dancer roller, and a roller control means for controlling the rotating speed of the deposition rollers located at both sides of the connection chamber unit based on the position of the dancer roller detected by the position detection means.

According to such a configuration in which the rotating speed of the deposition rollers located at both sides is controlled according to the position of the dancer roller, the position of the dancer roller can be kept at a specific position. Therefore, the displacement margin of the dancer roller can be appropriately secured, and the substrate can thus be transferred while appropriately maintaining the tension of the substrate.

The above-mentioned CVD apparatus may include, as the connection chamber unit, a one provided with a tension detection roller for detecting a tension acting on the substrate, and further include a roller control means which controls the rotating speed of the deposition rollers located at both sides of the connection chamber unit based on the tension detected by the tension detection roller.

By this configuration, also, the tension of the substrate can be kept constant. Therefore, the substrate can be smoothly transferred between the adjacent deposition chamber units while maintaining the tension of the substrate in an appropriate range.

### INDUSTRIAL APPLICABILITY

As described above, the CVD apparatus according to the present invention can efficiently perform deposition processing on a strip substrate such as a film or sheet while preventing a conveyance flaw by entangling of a peeled film, and is useful in the manufacturing field of semiconductor devices.

## Claims

1. A CVD apparatus (1) for forming a coating on a surface of a sheet-like substrate (W) by plasma CVD, comprising:
a plurality of deposition chamber units (6) each including deposition rollers (2) and a deposition unit chamber (60) for housing said deposition rollers (2), said deposition chamber units (6) being arranged so that each deposition roller (2) is aligned in a specific horizontal direction; and
a connection chamber unit (7) which is interposed between mutually adjacent deposition chamber units (6) of said deposition chamber units (6) to mutually connect the adjacent deposition chamber units (6), wherein
said connection chamber unit (7) includes a connection unit chamber (70) which connects the adjacent deposition chamber units (6) to each other by being connected to each deposition unit chamber (60) of the adjacent deposition chamber units (6), and
said deposition rollers (2) of each deposition chamber unit (6) are arranged so that the substrate (W) is transferred while being rolled on said respective deposition rollers (2), and are configured so that plasma for decomposing a source gas (G_{A}) is formed, upon receiving application of a voltage, in the vicinity of said deposition rollers (2) to perform deposition processing on the substrate (W) on said deposition rollers (2),
wherein each deposition chamber unit (6) includes, as said deposition rollers (2), a pair of opposed rollers (2) which are opposed with a space therebetween for forming the plasma so that the shaft centers thereof are parallel to each other,
wherein said deposition chamber unit (6) includes a deposition area partition member (10) which partitions the inside of said deposition unit chamber (60) into a deposition area (A) that is a part or all of the area on the side where said pair of opposed rollers (2) are opposed to each other and a pressurized area (B) that is the peripheral area of the deposition area (A) while allowing the passage of the substrate (W), the deposition area (A) is filled with the source gas (G_{A}), and the pressurized area is filled with a pressurized discharge gas (G_{B}) higher in pressure than the source gas (G_{A}).

2. The CVD apparatus (1) according to claim 1, wherein the device further comprises a delivery chamber unit (5) including a feed roller (4) from which the substrate (W) is unwound and a delivery unit chamber (50) for housing said feed roller (4); and a takeup chamber unit (9) including a takeup roller (8) on which the substrate (W) is wound up and a takeup unit chamber (90) for housing said takeup roller (8), and said deposition chamber units (6) and said connection chamber unit (7) are disposed between said delivery chamber unit (5) and said takeup chamber unit (9).

3. The CVD apparatus according to claim 1, wherein the device comprises a differential pressure interruption means (11) which partitions the inside of said deposition unit chamber (60) of said deposition chamber unit (6) from the inside of said connection unit chamber (70) of said connection chamber unit (7) while allowing the passage of the substrate (W), and the inside of said connection unit chamber (70) of said connection chamber unit (7) is kept at a pressure lower than in the inside of said deposition unit chamber (60) of said deposition chamber unit (6).

4. The CVD apparatus (1) according to claim 1, wherein said connection chamber unit (7) includes a dancer roller (12b) for keeping the tension of the substrate (W) constant by displacing according to a change in length of the substrate (W) between said deposition rollers (2) located at both sides of said connection chamber unit (7).

5. The CVD apparatus according to claim 4, wherein the device comprises a position detection means for detecting a position of said dancer roller (12b), and a roller control means (13) for controlling the rotating speed of said deposition rollers (2) located at both sides of said connection chamber unit (7) based on the position of said dancer roller (12b) detected by said position detection means.

6. The CVD apparatus (1) according to claim 1, wherein the device comprises, as said connection chamber unit (7), a one provided with a tension detection roller (23) for detecting a tension acting on the substrate (W), and further comprises a roller control means (13) which controls the rotating speed of said deposition rollers (2) located at both sides of said connection chamber unit (2) based on the tension detected by said tension detection roller (23).

## Patentansprüche

1. CVD-Vorrichtung (1) zum Ausbilden einer Beschichtung an einer Fläche eines plattenartigen Substrats (W) durch Plasma-CVD, mit:
einer Vielzahl von Abscheidungskammereinheiten (6), die jeweils Abscheidungswalzen (2) und eine Abscheidungseinheitkammer (60) zum Aufnehmen der Abscheidungswalzen (2) enthalten, wobei die Abscheidungskammereinheiten (6) angeordnet sind, sodass jede Abscheidungswalze (2) in einer spezifischen Horizontalrichtung ausgerichtet ist; und
eine Verbindungskammereinheit (7), die zwischen zueinander benachbarten Abscheidungskammereinheiten (6) der Abscheidungskammereinheiten (6) angeordnet ist, um die benachbarten Abscheidungskammereinheiten (6) miteinander zu verbinden, wobei
die Verbindungskammereinheit (7) eine Verbindungseinheitkammer (70) enthält, die die benachbarten Abscheidungskammereinheiten (6) dadurch miteinander verbindet, dass diese mit jeder Abscheidungseinheitkammer (60) der benachbarten Abscheidungskammereinheiten (6) verbunden ist, und
die Abscheidungswalzen (2) von jeder Abscheidungskammereinheit (6) angeordnet sind, sodass das Substrat (W) weitergegeben wird, während es auf den jeweiligen Abscheidungswalzen (2) gerollt wird, und gestaltet sind, sodass beim Erhalten einer Spannungsbeaufschlagung Plasma zum Zerlegen eines Quellengases (G_{A}) in der Nähe der Abscheidungswalzen (2) ausgebildet wird, um eine Abscheidungsbearbeitung auf dem Substrat (B) an den Abscheidungswalzen (2) durchzuführen,
wobei jede Abscheidungskammereinheit (6) als die Abscheidungswalzen (2) ein Paar gegenüberliegende Walzen (2) enthält, die mit einem Raum dazwischen zum Ausbilden des Plasmas gegenüberliegend sind, sodass deren Wellenmitten parallel zueinander sind,
wobei die Abscheidungskammereinheit (6) ein Abscheidungsbereichsteilungsbauteil (10) enthält, das das Innere der Abscheidungseinheitkammer (60) in einen Abscheidungsbereich (A), der ein Teil oder alles von dem Bereich an der Seite ist, wo das Paar gegenüberliegende Walzen (2) einander gegenüberliegen sind, und einen druckbeaufschlagten Bereich (B) trennt, der ein Peripheriebereich des Abscheidungsbereichs (A) ist, während der Durchgang des Substrats (W) möglich ist, wobei der Abscheidungsbereich (A) mit dem Quellengas (G_{A}) gefüllt ist und der druckbeaufschlagte Bereich mit einem druckbeaufschlagten Entladegas (G_{B}) mit einem höheren Druck als das Quellengas (G_{A}) gefüllt ist.

2. CVD-Vorrichtung (1) gemäß Anspruch 1, wobei die Vorrichtung des Weiteren eine Eingabekammereinheit (5), die eine Zuführwalze (4), von der das Substrat (B) abgewickelt wird, und eine Eingabeeinheitkammer (50) zum Aufnehmen der Zuführwalze (4) enthält; und eine Aufnahmekammereinheit (9) aufweist, die eine Aufnahmewalze (8), an der das Substrat (W) aufgewickelt wird, und eine Aufnahmeeinheitkammer (90) zum Aufnehmen der Aufnahmewalze (8) enthält, und die Abscheidungskammereinheiten (6) und die Verbindungskammereinheit (7) zwischen der Eingabekammereinheit (5) und der Aufnahmekammereinheit (9) angeordnet sind.

3. CVD-Vorrichtung gemäß Anspruch 1, wobei die Vorrichtung eine Differenzdrucktrennungseinrichtung (11) aufweist, die das Innere der Abscheidungseinheitkammer (60) der Abscheidungskammereinheit (6) von dem Inneren der Verbindungseinheitkammer (70) der Verbindungskammereinheit (7) trennt, während der Durchgang des Substrats (W) möglich ist, und das Innere der Verbindungseinheitkammer (70) der Verbindungskammereinheit (7) auf einen Druck gehalten wird, der niedriger als der im Inneren der Abscheidungseinheitkammer (60) der Abscheidungskammereinheit (6) ist.

4. CVD-Vorrichtung (1) gemäß Anspruch 1, wobei die Verbindungskammereinheit (7) eine Pendelwalze (12b) enthält, um die Spannung des Substrats (W) durch ein Verlagern gemäß einer Änderung in einer Länge des Substrats (W) zwischen den Abscheidungswalzen (2), die an beiden Seiten der Verbindungskammereinheit (7) gelegen sind, konstant zu halten.

5. CVD-Vorrichtung gemäß Anspruch 4, wobei die Vorrichtung eine Positionserfassungseinrichtung zum Erfassen einer Position der Pendelwalze (12b) und eine Walzensteuerungseinrichtung (13) zum Steuern der Rotationsgeschwindigkeit der Abscheidungswalzen (2), die an beiden Seiten der Verbindungskammereinheit (7) gelegen sind, basierend auf der Position der Pendelwalze (12b), die durch die Positionserfassungseinrichtung erfasst wird, aufweist.

6. CVD-Vorrichtung (1) gemäß Anspruch 1, wobei die Vorrichtung als die Verbindungskammereinheit (7) eine aufweist, die mit einer Spannungserfassungswalze (23) zum Erfassen einer Spannung, die an dem Substrat (W) wirkt, versehen ist, und des Weiteren eine Walzensteuerungseinrichtung (13) aufweist, die die Rotationsgeschwindigkeit der Abscheidungswalzen (2), die an beiden Seiten der Verbindungskammereinheit (2) gelegen sind, basierend auf der Spannung, die durch die Spannungserfassungswalze (23) erfasst wird, steuert.

## Revendications

1. Appareil (1) de dépôt chimique en phase vapeur (CVD) permettant de former un revêtement sur une surface d'un substrat en forme de feuille (W) par CVD au plasma, comprenant :
une pluralité d'unités formant chambres de dépôt (6) comportant chacune des rouleaux de dépôt (2) et une chambre unitaire de dépôt (60) destinée à loger lesdits rouleaux de dépôt (2), lesdites unités formant chambres de dépôt (6) étant agencées de telle sorte que chaque rouleau de dépôt (2) est aligné dans une direction horizontale spécifique ; et
une unité formant chambre de liaison (7) qui s'intercale entre des unités formant chambres de dépôt (6) mutuellement adjacentes desdites unités formant chambres de dépôt (6) afin de relier entre elles les unités formant chambres de dépôt (6) adjacentes, dans lequel
ladite unité formant chambre de liaison (7) comporte une chambre unitaire de liaison (70) qui relie les unités formant chambres de dépôt (6) adjacentes entre elles en étant reliée à chaque chambre unitaire de dépôt (60) des unités formant chambres de dépôt (6) adjacentes, et
lesdits rouleaux de dépôt (2) de chaque unité formant chambre de dépôt (6) sont agencés de telle sorte que le substrat (W) est transféré pendant qu'il s'enroule sur lesdits rouleaux de dépôt (2) respectifs, et sont configurés de telle sorte qu'un plasma destiné à décomposer un gaz source (G_{A}) se forme, lors de l'application d'une tension, à proximité desdits rouleaux de dépôt (2) pour effectuer un traitement de dépôt sur le substrat (W) sur lesdits rouleaux de dépôt (2),
dans lequel chaque unité formant chambre de dépôt (6) comporte, au titre desdits rouleaux de dépôt (2), une paire de rouleaux opposés (2) qui s'opposent avec un espace entre eux pour former le plasma de telle sorte que leurs axes sont parallèles entre eux,
dans lequel ladite unité formant chambre de dépôt (6) comporte un élément de séparation de zone de dépôt (10) qui sépare la partie intérieure de ladite chambre unitaire de dépôt (60) en une zone de dépôt (A) qui correspond à une partie ou à la totalité de la zone du côté où ladite paire de rouleaux opposés (2) s'opposent l'un à l'autre et une zone sous pression (B) qui correspond à la zone périphérique de la zone de dépôt (A) tout en autorisant le passage du substrat (W), la zone de dépôt (A) est remplie avec le gaz source (G_{A}), et la zone sous pression est remplie avec un gaz de décharge sous pression (G_{B}) dont la pression est supérieure à celle du gaz source (G_{A}).

2. Appareil de CVD (1) selon la revendication 1, dans lequel le dispositif comprend en outre une unité formant chambre de distribution (5) comportant un rouleau d'alimentation (4) à partir duquel le substrat (W) est déroulé et une chambre unitaire de distribution (50) destinée à loger ledit rouleau d'alimentation (4) ; et une unité formant chambre réceptrice (9) comportant un rouleau récepteur (8) sur lequel le substrat (W) s'enroule et une chambre unitaire réceptrice (90) destinée à loger ledit rouleau récepteur (8), et lesdites unités formant chambres de dépôt (6) et ladite unité formant chambre de liaison (7) sont disposées entre ladite unité formant chambre de distribution (5) et ladite unité formant chambre réceptrice (9).

3. Appareil de CVD selon la revendication 1, dans lequel le dispositif comprend des moyens d'interruption à pression différentielle (11) qui séparent la partie intérieure de ladite chambre unitaire de dépôt (60) de ladite unité formant chambre de dépôt (6) de la partie intérieure de ladite chambre unitaire de liaison (70) de ladite unité formant chambre de liaison (7) tout en autorisant le passage du substrat (W), et la partie intérieure de ladite chambre unitaire de liaison (70) de ladite unité formant chambre de liaison (7) est maintenue à une pression inférieure à celle de la partie intérieure de ladite chambre unitaire de dépôt (60) de ladite unité formant chambre de dépôt (6).

4. Appareil de CVD (1) selon la revendication 1, dans lequel ladite unité formant chambre de liaison (7) comprend un rouleau compensateur (12b) destiné à maintenir la tension du substrat (W) constante en se déplaçant en fonction d'un changement de longueur du substrat (W) entre lesdits rouleaux de dépôt (2) situés des deux côtés de ladite unité formant chambre de liaison (7).

5. Appareil de CVD selon la revendication 4, dans lequel le dispositif comprend des moyens de détection de position permettant de détecter une position dudit rouleau compensateur (12b), et des moyens de commande de rouleau (13) permettant de commander la vitesse de rotation desdits rouleaux de dépôt (2) situés des deux côtés de ladite unité formant chambre de liaison (7) en fonction de la position dudit rouleau compensateur (12b) détectée par lesdits moyens de détection de position.

6. Appareil de CVD (1) selon la revendication 1, dans lequel le dispositif comprend, au titre de ladite unité formant chambre de liaison (7), une chambre pourvue d'un rouleau de détection de tension (23) permettant de détecter une tension s'exerçant sur le substrat (W), et comprend en outre des moyens de commande de rouleau (13) qui commandent la vitesse de rotation desdits rouleaux de dépôt (2) situés des deux côtés de ladite unité formant chambre de liaison (2) en fonction de la tension détectée par ledit rouleau de détection de tension (23).
